# DEMANDE DE BREVET EUROPEEN

(11) **EP 4 793 780 A1**
(43) Date de publication de la demande: **19.08.2026**
(21) Numéro de dépôt: 26158180.5
(22) Date de dépôt: 12.02.2026
(51) Int. Cl.: G06F 12/02, G11C 11/56, G06F 3/06, G11C 7/20, G11C 16/10, G11C 16/08

(54) **PROCÉDÉ DE TRADUCTION FLASH, ORDINATEUR DE BORD IMPLÉMENTANT CE PROCÉDÉ, ET LANCEUR SPATIAL AINSI ÉQUIPÉ**

(30) Priorité: 12.02.2025 FR 2501447
(71) Demandeur: Latitude, 51100 Reims (FR)
(72) Inventeur: SMADJA, Rémo, 51100 REIMS (FR); ROUSSEAU, Clément, 51100 REIMS (FR)
(74) Mandataire: IP Trust

(57) **Abrégé**

Procédé de traduction flash prévu pour convertir des adresses logiques dans une mémoire vive (RAM) en adresses physiques dans une mémoire flash (2), caractérisé en ce qu'il est mis en œuvre dans un système ordinateur (100) embarqué dans un lanceur spatial (1) et incluant ladite mémoire vive (RAM) et ladite mémoire flash (2), pour écrire dans ladite mémoire flash (2) des données issues de fichiers de mission et de configuration qui ont été transmis au système ordinateur embarqué (100) alors que le lanceur spatial (1) est encore sur un pas de tir (5) et qui sont préalablement chargés dans la mémoire vive (RAM), ainsi que pour l'enregistrement et le stockage de données en continu en vol.

## Description

### DOMAINE DE L'INVENTION

La présente invention concerne un procédé de traduction flash. Elle vise également un ordinateur de bord implémentant ce procédé, ainsi qu'un lanceur spatial équipé de cet ordinateur de bord.

### ETAT DE LA TECHNIQUE

Un ordinateur de bord d'un lanceur spatial, qui est conçu pour stocker des données de tailles hétérogènes, peut employer un dispositif mémoire flash NAND. Certaines informations sont enregistrées une seule fois au début de la campagne de lancement et d'autres mises à jour plusieurs fois au cours du lancement.

Une mémoire flash NAND est une type de mémoire EEPROM (Electrically Erasable Programmable Read-Only Memory), un dispositif entièrement électronique qui, contrairement à ses homologues mécaniques tels que les disques durs ou les bandes magnétiques, offre une résistance relativement élevée aux vibrations et aux chocs, des performances élevées - notamment pour les accès aléatoires -, et qui peut se présenter sous des formats très réduits, bien qu'il n'offre pas nécessairement la plus haute densité de données.

Cependant, ces avantages ont un coût, qui est lié à l'architecture et aux contraintes opérationnelles de ces dispositifs. Dans les dispositifs flash NAND, les données sont programmées par « pages » entières, souvent de plusieurs milliers d'octets. Une fois écrites, ces pages doivent être effacées avant qu'il soit possible de les écrire à nouveau. En outre, la mémoire flash NAND ne peut être effacée que par un « secteur » entier à la fois, qui peut contenir plus d'une centaine de pages, un processus qui prend généralement quelques dizaines de millisecondes à exécuter.

De manière simple, pour modifier le contenu d'une adresse spécifique dans une mémoire flash NAND, il faudrait que le logiciel interfaçant avec ce dispositif copie le contenu de l'ensemble du secteur contenant cette adresse dans une mémoire RAM, modifie les données dans la RAM, efface le secteur flash et réécrive l'ensemble du secteur. Un tel processus, s'il était utilisé à chaque demande d'accès en écriture aléatoire, induirait de très mauvaises performances en écriture.

Il est donc nécessaire d'implémenter un algorithme adapté pour éviter autant que possible le recours à l'effacement de secteurs. Ce type de logiciel a été largement développé pour le marché des ordinateurs personnels pour que ces derniers soient utilisés avec les disques à semi-conducteurs SSD à base de mémoire flash NAND afin de permettre aux anciens pilotes (*drivers*) d'utiliser la technologie flash NAND, les disques durs n'étant pas concernés par ces problèmes. Ce logiciel est appelé une couche de traduction flash FTL, pour *Flash Translation Layer.*

Ces logiciels FTL ont des performances hétérogènes car la stratégie qu'ils utilisent résulte généralement d'un compromis entre plusieurs critères tels que les performances d'écriture séquentielle, les performances d'écriture à accès aléatoire, l'utilisation de la technologie flash, l'utilisation de la mémoire RAM, les effets d'usure et la robustesse à la perte de puissance ou au redémarrage.

Le cas d'utilisation dans un ordinateur embarqué OBC pour « *On-Board Computer »* est assez spécifique car le logiciel FTL doit alors être complètement résilient à la perte de puissance/au redémarrage et maximiser les performances d'écriture à accès aléatoire, alors que les autres critères ne sont pas vraiment préoccupants.

Une implémentation FTL spécifique doit donc être développée pour cet usage spécifique, ce qui offre également la possibilité de garantir sa robustesse à l'aide de SPARK, un sous-ensemble du langage de programmation Ada utilisé pour les logiciels à haute intégrité.

### EXPOSE DE L'INVENTION

Cet objectif est atteint avec un procédé de traduction flash prévu pour convertir des adresses logiques dans une mémoire vive (RAM) en adresses physiques dans une mémoire flash, caractérisé en ce qu'il est mis en œuvre dans un système ordinateur embarqué dans un lanceur spatial et incluant ladite mémoire vive (RAM) et ladite mémoire flash, pour écrire dans ladite mémoire flash des données issues de fichiers de mission et de configuration qui ont été transmis audit système ordinateur embarqué alors que ledit lanceur spatial est encore sur un pas de tir et qui sont préalablement chargés dans ladite mémoire vive (RAM).

Il est à noter que la mémoire flash et le logiciel FTL vont aussi être utilisés pour réaliser l'enregistrement et le stockage de données en continu durant le vol.

Pour une mémoire flash organisée en tableau de mémoire flash, le tableau de mémoire flash est divisé en une zone de blocs de mappage (MBA) et une zone de blocs de données (DBA).

Le procédé de traduction flash selon l'invention peut en outre comprendre, à chaque fois qu'une page est écrite dans la mémoire flash, une étape pour ajouter une entrée à la zone de blocs de mappage (MBA), chaque entrée contenant un drapeau de validité, un numéro de page logique (LPN) et un numéro de page physique (PPN) qui lui est associé.

Il peut en outre comprendre une étape pour inscrire une copie d'une table de mappage de la mémoire vive (RAM) dans la mémoire flash, ladite copie étant exploitée en tant que table de recherche de mappage (MLT).

On peut aussi prévoir une étape pour indexer la table de recherche de mappage (MLT) par des numéros de page logique (LPN), ladite table de recherche de mappage (MLT) contenant le numéro de page physique (PPN) et un identifiant de mappage (MID), ainsi qu'une étape pour gérer un tableau de statuts de blocs (BSA) qui est indexé par un numéro de bloc et qui représente un nombre de pages valides par bloc et leurs statuts de liberté correspondants.

Le tableau de statuts de blocs (BSA) peut être avantageusement divisé en un premier sous-tableau de statuts de blocs de mappage (MBSA) et un second sous-tableau de blocs de données (DBSA).

Le procédé de traduction flash selon l'invention peut en outre comprendre une étape pour gérer un tableau d'invalidité sous la forme d'une table de recherche de validité (VLT) qui est indexée par le numéro de page physique (PPN).

On peut aussi prévoir que le procédé de traduction flash selon l'invention comprenne en outre une sauvegarde dans la mémoire vive (RAM) de :
- l'adresse du bloc de la mémoire flash en cours d'écriture, appelée page de données actuelle (CDP),
- l'adresse de la dernière adresse d'identifiant de mappage (MID), appelée page de mappage actuelle (CMP),
- du nombre de blocs libres.

Le procédé de traduction flash selon l'invention peut en outre comprendre un processus d'initialisation mis en œuvre au démarrage d'un lancement du lanceur spatial, ledit processus d'initialisation comprenant une étape pour lire la première page de chaque bloc du tableau de blocs de mappage (MBA), cette étape de lecture comprenant les étapes suivantes :
- lecture d'une valeur de validité d'une première unité dudit tableau de blocs de mappage (MBA),
- si cette valeur est différente de 0xF, lecture de toutes les pages successives dudit bloc jusqu'à atteindre une validité de 0xF.

Le processus d'initialisation peut aussi être implémenté dans une situation de redémarrage du lancement et comprend une lecture du tableau de blocs de mappage (MBA) préalablement sauvegardé dans la mémoire flash.

Le processus d'initialisation peut en outre comprendre une étape pour construire, au démarrage ou redémarrage du lancement, la table de recherche de mappage (MLT) et/ou le tableau de statuts de blocs (BSA) et/ou la table de recherche de validité (VLT) basées sur une unité valide du tableau de blocs de mappage (MBA).

Le procédé de traduction flash peut aussi comprendre un processus d'écriture dans la mémoire flash, ledit processus d'écriture comprenant les étapes suivantes :
- obtenir un nouveau numéro de page physique PPN libre sur lequel écrire,
- écrire des données à cette adresse dans la mémoire flash.

On peut aussi prévoir pour le processus d'écriture les étapes suivantes :
- récupérer l'ancien ensemble d'entrées pour un numéro de page logique LPN donné,
- si l'entrée est valide,
   - invalider cette entrée dans la table de recherche de validité VLT et le tableau de blocs de mappage MBA et
   - diminuer le nombre de pages valides dans le bloc correspondant dans le tableau de statut de blocs BSA,
   - obtenir un nouvel identifiant de mappage MID libre,
- y écrire la nouvelle entrée dans le tableau MBA et
- mettre à jour les tables de recherche de mappage MLT et de recherche de validité VLT.

Le procédé de traduction flash selon l'invention peut en outre comprendre un processus d'allocation d'un numéro de page physique, ce procédé d'allocation comprenant une étape pour attribuer un nouveau numéro de page physique (NPP) par incrémentation de la valeur de page de données actuelle (CDP) et incrémentation de la valeur de bloc si le bloc de données actuel est plein.

Le procédé de traduction flash selon l'invention peut en outre comprendre un processus d'invalidation de page, ce processus d'invalidation comprenant une étape pour sauvegarder des données sur les pages qui sont invalides de façon à fournir ces données d'invalidité à un logiciel de collecte de déchets prévu pour libérer de la mémoire.

Un processus de récupération de blocs peut aussi être prévu dans le cadre du procédé de traduction flash selon l'invention, ce bloc de récupération comprenant les étapes suivantes :
- sélectionner un bloc rempli avec le plus grand nombre de pages non valides,
- déplacer les pages valides vers le bloc de données actuellement écrit, et
- effacer ce bloc pour créer un nouveau bloc libre.

Le processus de récupération de blocs peut en outre comprendre les étapes suivantes :
- surveiller périodiquement la quantité de blocs libres disponibles et
- créer des blocs libres chaque fois que cette quantité passe sous un certain seuil.

Suivant un autre aspect de l'invention, il est proposé un système ordinateur de bord embarqué dans un lanceur spatial, comprenant une unité de contrôle et de traitement, une unité mémoire RAM prévue pour recevoir des fichiers système transmis depuis un segment sol et une unité mémoire flash prévue pour y écrire des données de mission et de configuration contenus dans lesdits fichiers système, ladite unité de contrôle et de traitement implémentant un procédé de traduction flash selon l'invention pour écrire lesdites données de mission et de configuration dans ladite unité mémoire flash.

Suivant encore un autre aspect de l'invention, il est proposé un lanceur spatial équipé d'un système ordinateur de bord selon l'invention.

La couche de traduction flash selon l'invention est définie par un cycle de vie très court sans réutilisabilité en dehors des paramètres de mission, une marge de capacité mémoire élevée et un fort besoin de résilience au redémarrage et de vitesse de récupération pendant cette période. D'une part, le système logiciel embarqué OBS pour « *On-Board Software* » doit être résilient à un redémarrage, car il s'agit de la principale réaction à un crash logiciel. Plus précisément, ce type de redémarrage est un redémarrage non coopératif déclenché soit par le chien de garde (pour *« watch Dog »*) matériel, soit par un gestionnaire de dernière chance logiciel, ce qui signifie que le logiciel n'aura pas le temps de faire un peu de « tenue de compte » pour « *book keeping »* avant de s'arrêter.

Par conséquent, la couche de traduction flash FTL doit être conçue de manière à ce que chaque fois qu'un redémarrage se produit pendant les activités flash, il n'y ait aucune perte de données flash ou une perte très limitée. Cela constitue les plus grandes exigences de ce concept.

D'un autre côté, comme les capacités de mémoire flash et de mémoire vive RAM de l'ordinateur de bord OBC ont été spécifiées avec des marges et que la mission d'un lanceur spatial a une durée de vie courte, la couche de traduction flash selon l'invention diffère de la plupart des implémentations FTL antérieures utilisées soit pour des ordinateurs de bureau soit pour des appareils embarqués, car ces dernières s'appuient généralement sur des arrêts coopératifs pour avoir le temps de limiter la perte de données et mettent beaucoup d'efforts dans le nivellement de l'usure pour *« wear levelling »,* la technique utilisée pour suivre la fatigue de chaque page de mémoire et l'équilibrer entre tous les secteurs, afin d'améliorer l'espérance de vie d'une mémoire flash NAND.

Cela implique deux choses. La première est que le nivellement de l'usure n'est pas vraiment un problème car le calculateur de bord OBC n'est utilisé que pour un seul vol, donc la résilience typique de dizaines de milliers de cycles d'effacement/programmation de la mémoire flash NAND est largement suffisante pour ne pas se soucier de l'usure. La deuxième est qu'il y a suffisamment d'espace mémoire dans la mémoire flash et la mémoire RAM pour avoir une surcharge spatiale substantielle. Cela donne beaucoup de marge de manœuvre à la couche de traduction flash pour l'efficacité et la résilience en échange de l'espace mémoire. Enfin, les performances d'écriture et surtout les calculs CPU supplémentaires causés par la surcharge de la couche de traduction flash selon l'invention doivent également être hautement optimisés en termes de temps pour éviter d'affecter les capacités en temps réel de l'OBS. À l'heure actuelle, l'utilisation typique devrait être l'écriture à accès aléatoire bien plus que l'écriture séquentielle.

### DESCRIPTION DES FIGURES

[Fig. 1] La Figure 1 illustre schématiquement un lanceur spatial doté d'une couche de traduction flash selon l'invention, (A) sur son pas de tir et (B) en vol ;
[Fig. 2] La Figure 2 représente un diagramme de connectivité d'une couche de traduction flash générique FTL selon l'invention ;
[Fig. 3] La Figure 3 illustre une répartition entre une zone de bloc de mappage MBA et une zone de bloc de données DBA dans une couche de traduction flash selon l'invention ;
[Fig. 4] La Figure 4 illustre une représentation d'une unité dans une zone de bloc de mappage MBA ;
[Fig. 5] La Figure 5 illustre une représentation d'une unité dans une table de recherche de mappage MLT ;
[Fig. 6] La Figure 6 illustre une structure générale d'un tableau de statut de bloc BSA ;
[Fig. 7] La Figure 7 illustre une représentation d'unités dans un tableau de statut de bloc BSA ; et
[Fig. 8] La figure 8 illustre une représentation d'une unité dans un tableau de recherche de validité VLT.

### DESCRIPTION DETAILLEE

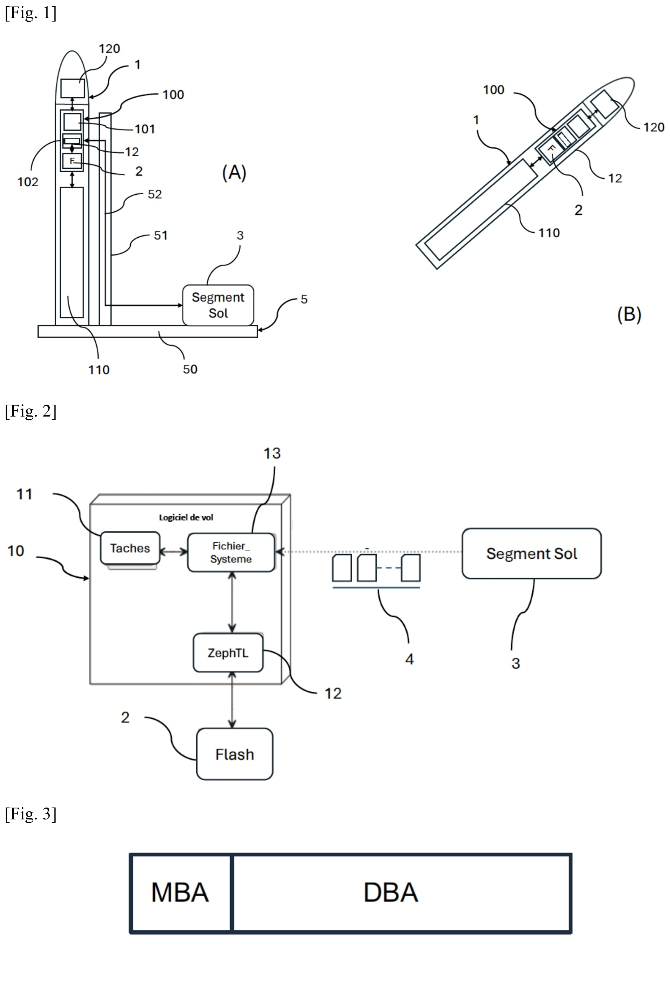

Un lanceur spatial 1 selon l'invention comprend, en référence à la figure 1, un système ordinateur de bord 100 qui contrôle et commande un ensemble de propulsion 110 et des équipements embarqués 120 dans la coiffe du lanceur 1.

Ce lanceur spatial 1 est disposé initialement sur un pas de tir 5 comportant une base de lancement 50, une tour de connexion et d'alimentation 51 du lanceur 1 avant son décollage et une base de contrôle commande au sol - le segment sol- 3.

Le système ordinateur de bord 100 comporte une unité de contrôle et de traitement 102 implémentant un logiciel de vol et une couche de traduction flash 12 selon l'invention, une mémoire vive RAM 101 et une mémoire flash 2.

Pendant une phase préparatoire au lancement, durant laquelle le lanceur spatial 1 est disposé sur le pas de tir 5, le segment sol 3 transmet via un système de transmission numérique 52, qui peut être filaire on non filaire, à l'ordinateur de bord un ensemble 4 de fichiers de mission et de configuration qui sont chargés dans la mémoire RAM 101 du système ordinateur de bord 100. Le logiciel de bord exécuté par l'ordinateur de bord 100 installe ces fichiers de mission et de configuration 4 dans un système de fichiers 13 auxquelles sont associées des taches 11 de contrôle et de commande des équipements embarqués au sein du lanceurs spatial 1.

La couche de traduction flash 12 selon l'invention est interposée entre le fichier de systèmes et la mémoire flash 2.

### Architecture logicielle

On donne ci-dessous, en référence à la Figure 2, une représentation schématique du composant échangeant des données avec la mémoire flash 2 via le programme de couche de traduction 12 selon l'invention pour la mission du lanceur spatial.

La couche de traduction flash 12 selon l'invention est conçue pour éviter d'avoir à effacer un bloc entier à chaque écrasement, ce qui consiste à copier les données de page modifiées sur une autre page libre. Le logiciel implémentant la couche de traduction flash 12 doit garder une trace de l'endroit où chaque page est physiquement stockée dans la mémoire flash 2.

Cela est réalisé à l'aide d'une table de mappage qui associe un numéro de page logique (LPN) à un numéro de page réel où il est stocké dans la mémoire flash, appelé numéro de page physique (PPN). Ainsi, la couche de traduction flash selon l'invention est le seul lien entre le logiciel de vol, essentiellement via son système de fichiers, et la puce de mémoire flash 2.

### Utilisation de la mémoire flash

La matrice flash 2 est ensuite divisée en deux zones comme l'illustre la figure 3 :
- une zone de blocs de mappage (pour *« Mapping Block Area* ») MBA, contenant les informations de mappage et
- une zone de blocs de données (pour « *Data Block Area »*) DBA, qui contient les données utilisateur.

Les informations de mappage sont entièrement stockées dans la mémoire flash 2 et mises à jour à chaque modification pour être résilientes à un redémarrage non coopératif.

A chaque fois qu'une page est écrite en mémoire flash 2, une entrée est ajoutée à la zone de blocs de mappage MBA. Chaque entrée contient un indicateur de validité, un numéro de page logique LPN et son numéro de page physique PPN associé.

L'indicateur de validité indique, en référence à la figure 4, que la page désignée par le PPN correspondant est valide, c'est-à-dire qu'elle contient des données à jour, elle sera soit égale à 0xF lorsque l'unité est libre d'être écrite, 0x1 lorsque l'adresse associée est valide, et 0x0 lorsqu'elle est invalide.

Comme une unité de la zone de blocs de mappage MBA ne représente que 40 bits de mémoire, plusieurs unités peuvent tenir dans une page. Ainsi, pour suivre ces unités, on peut leur attribuer un numéro d'index, qui représente leur emplacement dans la page correspondante démarrée depuis son début.

### Utilisation de la mémoire RAM

Pour réduire la charge et le temps de traitement pendant les opérations, quatre schémas de mappage seront conservés et maintenus dans la mémoire RAM 101.

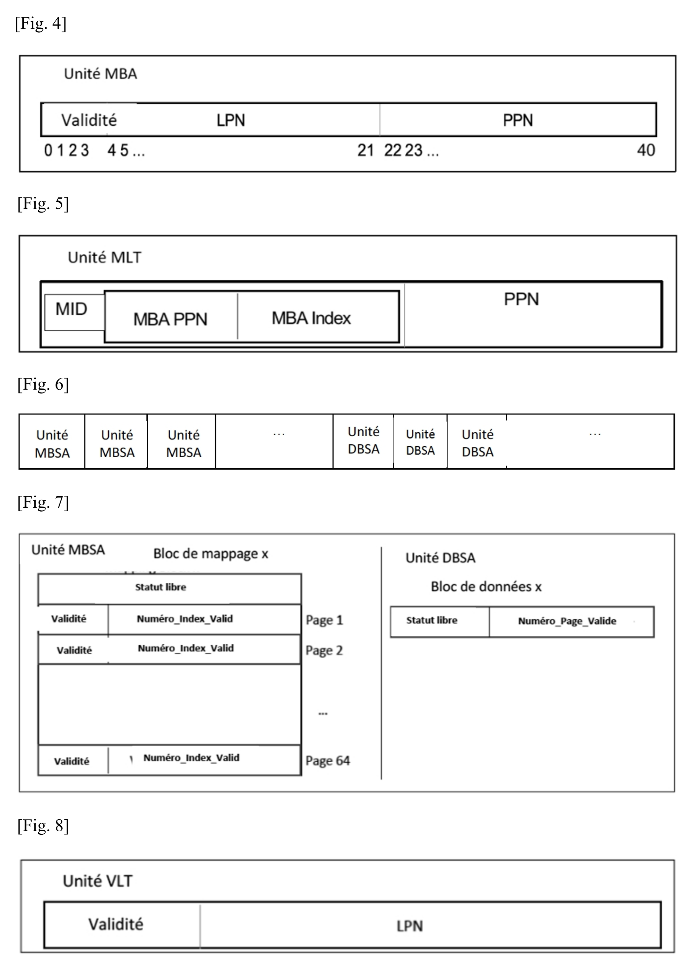

Une copie de la table de mappage conservée dans la mémoire flash 102, appelée Mapping Lookup Table, ou MLT, est indexée par des numéros LPN et contient le numéro de page physique PPN correspondant ainsi que l'identifiant ID de mappage, ou MID, qui est le PPN et l'index de l'unité MBA correspondante, comme l'illustre la figure 5.

Un tableau, appelé *Block Status Array* ou BSA pour « tableau d'état de bloc », est indexé par le numéro de bloc et représenter le nombre de pages valides par bloc et leur statut Libre (pour *« Free »*)*.* Cela permet de gérer le schéma de « collecte des déchets » (pour « *garbage collection* »), qui est le processus de récupération du bloc avec le plus grand nombre de pages invalides pour les effacer et les libérer. Le tableau BSA est essentiellement divisé, en référence à la figure 6, en deux sous-tableaux, MBSA pour les blocs de mappage (pour *« Mapping Block Status Array »*) et DBSA pour les blocs de données (pour *« Data Block Status Array »*)*.*

Cette distinction est spécifiée par la nécessité de simplifier le suivi de l'état des pages des blocs de mappage puisque chaque page d'un bloc de mappage pourra contenir plusieurs unités MBA. Ainsi, le tableau MBSA contient le statut Libre du bloc, comme dans le tableau DBSA, mais le nombre de pages valides sera remplacé par un tableau indexé par le numéro de pages et contiendra le statut de validité de la page ainsi que le nombre d'unités MBA valides qu'elle contient, comme l'illustre la figure 7.

Un tableau des pages invalides est appelé Table de Recherche de validité (pour *Validity Lookup Table* ou VLT) et est indexé par le numéro de page physique PPN. Il contient une valeur de 1 bit qui représente la validité de la page correspondante et la valeur de page logique LPN qui lui est liée, en référence à la figure 8.

Cette table VLT permet au logiciel de couche de traduction flash selon l'invention de vérifier rapidement si la page correspondante est valide ou non.

Enfin, trois objets protégés sont sauvegardés :
- Le premier contient l'adresse du bloc en cours d'écriture et la dernière page écrite. Cet objet est appelé Page de données actuelle (pour « *Current Data Page »*) ou CDP.
- Le second contient l'adresse de la dernière adresse de l'identifiant de mappage MID et de l'index qui ont été sauvegardés. Cet objet est appelé Page de mappage actuelle (pour « *Current Mapping Page »*) ou CMP.
- Le dernier représente le nombre de blocs Libres pour aider à la tâche de collecte des déchets ou *« garbage collection* ». Cet objet est appelé Compte des blocs libres (pour *« Free Block Count »*) ou Free_Block_Count.

### Opérations

La couche de traduction Flash 12 selon l'invention, qui est le lien entre le programme du système de fichiers 13 et le pilote QSPI de la mémoire flash 2, gère toutes les opérations exécutées sur cette mémoire flash 2. De plus, sa mission principale est de gérer le cycle de vie de la mémoire flash 12 et de simplifier le travail du système de fichiers 13 en mappant toutes les adresses mémoire physiques à des adresses logiques. Ainsi, plusieurs opérations de couche de traduction flash FTL spécifiques sont nécessaires.

### Initialisation

Au démarrage ou au redémarrage, le procédé de traduction flash doit construire toutes les informations spécifiques au FTL. Afin de récupérer les données en cas de redémarrage sur la rampe de lancement ou pendant le vol, la première action du procédé de traduction flash selon l'invention est de lire le tableau de blocs de mappage MBA enregistré sur la mémoire flash 2.

Le procédé de traduction flash selon l'invention parcourt le tableau de blocs de mappage MBA, située dans des blocs de mémoire fixes, en regardant la première page de chaque bloc.

La fonction d'initialisation comprend une étape pour lire la première page de chaque bloc du tableau MBA. Cette étape de lecture comprend :
- une étape de lecture de la valeur de validité de sa première unité MBA et si la valeur est différente de 0xF,
- une étape de lecture de toutes les pages successives du bloc jusqu'à atteindre une valeur de validité de 0xF, et en même temps,
- une étape pour construire (ou reconstruire) la table de recherche de mappage MLT, le tableau de recherche de statut BSA et la table de recherche de validité VLT en fonction de ces unités MBA valides,
- une fois que la fin d'un bloc ou d'une unité MBA est atteinte avec un membre valide de valeur 0xF, un arrêt de lecture du bloc MBA actuel et un début de lecture du bloc suivant.

Le programme de couche de traduction flash selon l'invention peut implémenter un algorithme d'initialisation tel que celui décrit ci-dessous.

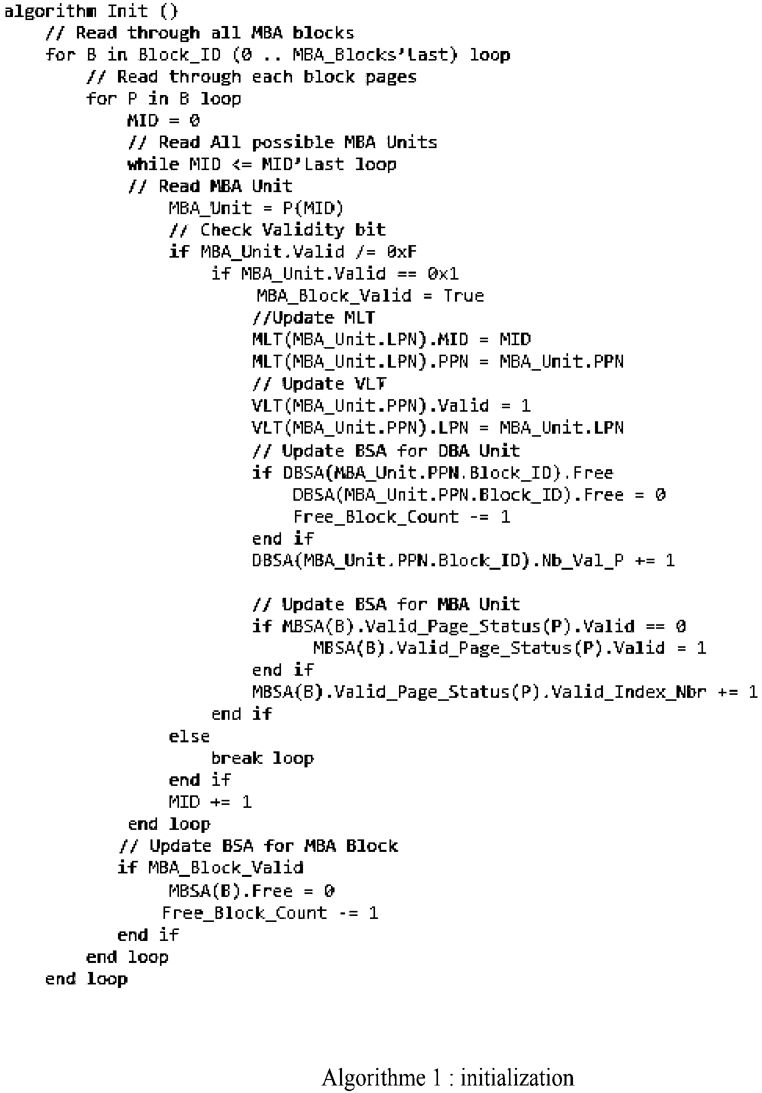

### Ecriture

Pour écrire dans la mémoire flash 2, le procédé de traduction flash selon l'invention comprend d'abord une étape pour obtenir un nouveau numéro de page physique PPN libre sur lequel écrire, suivie d'une étape pour écrire les données à cette adresse dans la mémoire flash.

Le procédé de traduction selon l'invention gère ensuite toutes les mises à jour de mappage. Il comprend en outre les étapes suivantes :
- récupérer l'ancien ensemble d'entrées pour un numéro de page logique LPN donné,
- si l'entrée est valide,
   ∘ invalider cette entrée dans la table de recherche de validité VLT et le tableau de blocs de mappage MBA et
   ∘ diminuer le nombre de pages valides dans le bloc correspondant dans le tableau de statut de blocs BSA,
   ∘ obtenir un nouvel identifiant de mappage MID libre,
   ∘ y écrire la nouvelle entrée dans le tableau MBA et
   ∘ mettre à jour les tables de recherche de mappage MLT et de recherche de validité VLT.

Ce processus d'écriture peut être implémenté sous la forme de l'algorithme d'écriture suivant :

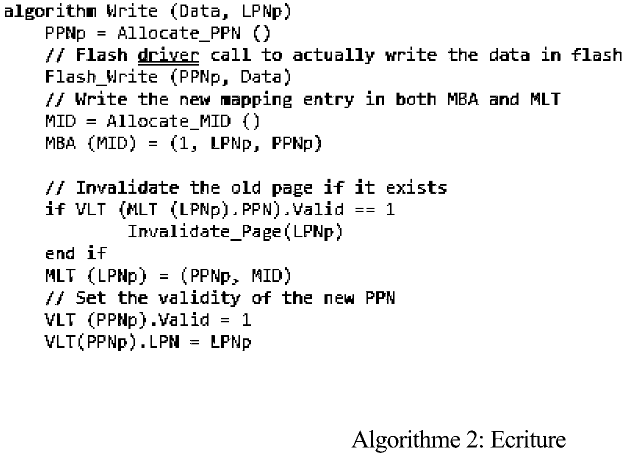

### Allocation d'un numéro de page physique

Un nouveau numéro de page physique est attribué simplement en incrémentant la valeur de page actuelle CDP et en incrémentant la valeur de bloc CDP si le bloc actuel de données est plein.

Ce processus d'écriture peut être implémenté sous la forme de l'algorithme d'allocation suivant :

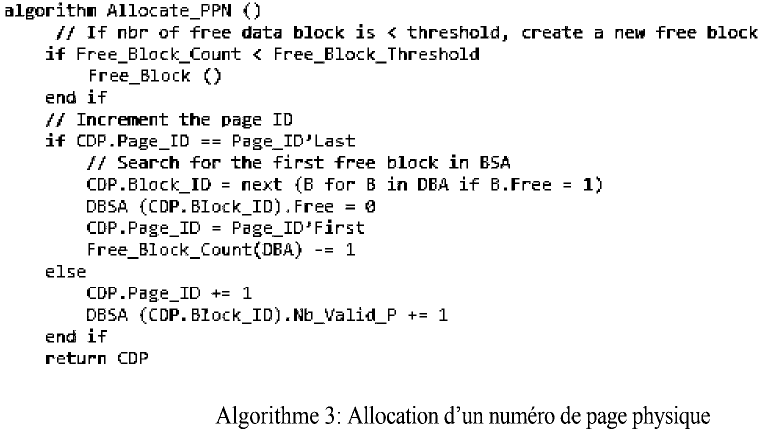

### Allocation d'un identifiant de mappage

Cette allocation est basée sur un algorithme similaire de l'algorithme 3 précédent.

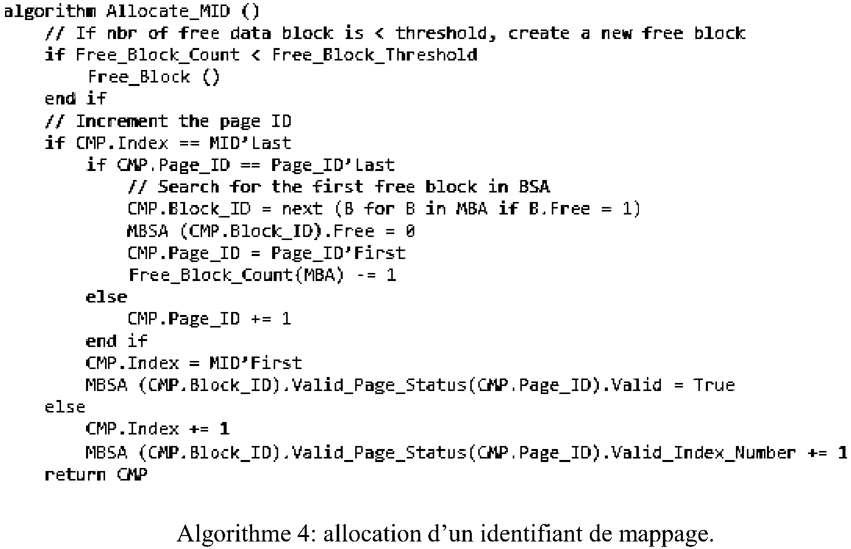

### Lecture

La lecture des données contenues dans la mémoire utilise seulement la table de recherche de mappage MLT pour récupérer le numéro de page physique PPN à partir du numéro de page logique LPN et lire dans la mémoire flash 2.

Ce processus de lecture peut être implémenté sous la forme de l'algorithme de lecture suivant :

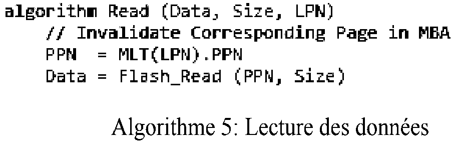

### Invalidation d'une page

Comme l'effacement d'une mémoire flash ne fonctionne que par blocs, il est nécessairement de mémoriser quelles pages sont invalides pour la prochaine fois que le « ramasse-miettes » (pour « garbage collector ») libérera de la mémoire.

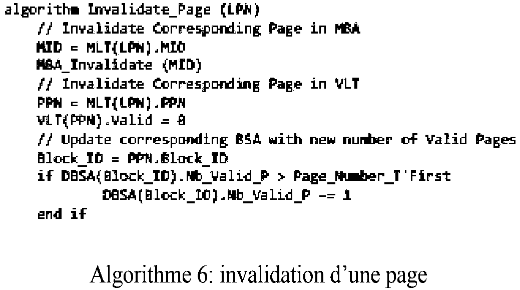

### Récupération d'un bloc

Au fur et à mesure que la mémoire flash se remplit de données et que les pages stockées dans des blocs complètement remplis sont mises à jour et déplacées vers un autre bloc, la quantité de blocs libres diminue au point où de nouveaux blocs libres doivent être générés pour pouvoir continuer à écrire des données.

Le processus de récupération de blocs au sein du procédé de traduction selon l'impression comprend alors les étapes suivantes :
- sélectionner le bloc rempli avec le plus grand nombre de pages non valides (la « victime »),
- déplacer ses pages valides vers le bloc de données actuellement écrit et
- effacer ce bloc pour créer un nouveau bloc libre.

Ce processus est assez long car l'effacement d'un secteur prend à lui seul des dizaines de millisecondes. Pour éviter d'ajouter une telle latence à une opération d'écriture lorsqu'un nouveau bloc libre est nécessaire, le processus de récupération de blocs comprend les étapes suivantes :
- surveiller périodiquement la quantité de blocs libres disponibles et
- créer des blocs libres chaque fois que cette quantité passe sous un certain seuil.

Ce processus de récupération de blocs peut être implémenté sous la forme de l'algorithme de récupération suivant :

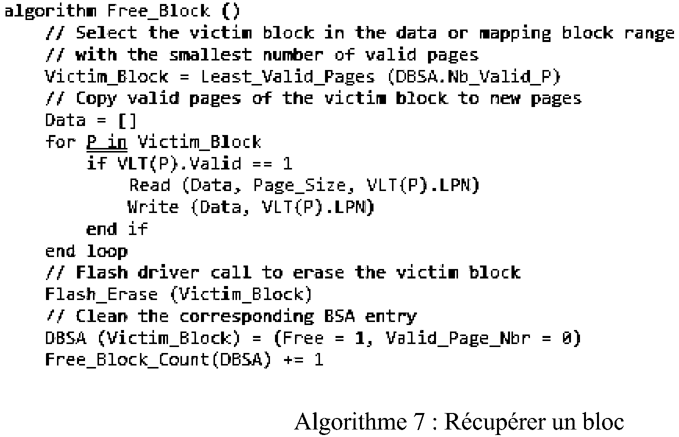

### Collecte des déchets

Le procédé de traduction flash selon l'invention réalise aussi une tâche de collecte des déchets, exécutée à intervalles réguliers, qui comprend les étapes suivantes :
- comparer la valeur du compteur de blocs libre, et
- si le nombre de blocs libres est inférieur à un certain seuil, appeler la fonction de récupération de blocs libres décrite ci-dessus.

L'algorithme 7 est ici défini pour la libération de block de la DBA, mais il est similaire dans le cas des blocks de la MBA.

Bien sûr, la présente invention n'est pas limitée aux modes de réalisation qui viennent d'être décrits et peut être implémentée de bien d'autres façons sans sortir du cadre de la présente invention.

### ACRONYMES ET DEFINITIONS

| Acronymes | Définitions | Signification |
|---|---|---|
| BSA | *Block Status Array* | Tableau d'état de bloc |
| CDP | *Current Data Page* | Page de données actuelle |
| DBA | *Data Block Area* | Zone de bloc de données |
| LPN | *Logical Page Number* | Numéro de page logique |
| PPN | *Physical Page Number* | Numéro de page physique |
| MID | *Mapping ID* | Identifiant de mappage |
| NAND | *NOT AND* | Non Et: opérateur Booléen |
| OBC | *On-Board Computer* | Calculateur embarqué |
| OBS | *On-board Software* | Logiciel embarqué |
| EEPROM | *Electrically Erasable Programmable Read-Only Memory* | Mémoire morte programmable effaçable électriquement |
| RAM | *Random Access Memory* | Mémoire vive |
| FTL | *Flash Translation Layer* | Couche de traduction Flash |
| HDD | *Hard Drive Disk* | Disque dur |
| MBA | *Mapping Block Area* | Zone de bloc de mappage |
| MLT | *Mapping Lookup Table* | Table de recherche de mappage |
| QSPI | *Quad serial peripheral interface* | Interface périphérique série quadruple |
| SSD | *Solid State Disk* | Disque à semi-conducteurs |
| VLT | *Validity Lookup Table* | Table de recherche de validité |
| CFP | *Current Free Page* | Page libre actuelle |

## Revendications

1. Procédé de traduction flash prévu pour convertir des adresses logiques dans une mémoire vive (RAM) en adresses physiques dans une mémoire flash (2), **caractérisé en ce qu'**il est mis en œuvre dans un système ordinateur (100) embarqué dans un lanceur spatial (1) et incluant ladite mémoire vive (RAM) et ladite mémoire flash (2), pour écrire dans ladite mémoire flash (2) des données issues de fichiers de mission et de configuration qui ont été transmis audit système ordinateur embarqué (100) alors que ledit lanceur spatial (1) est encore sur un pas de tir (5) et qui sont préalablement chargés dans ladite mémoire vive (RAM).

2. Procédé de traduction flash selon la revendication précédente, mis en œuvre pour une mémoire flash (2) organisée en tableau de mémoire flash, **caractérisé en ce que** le tableau de mémoire flash est divisé en une zone de blocs de mappage (MBA) et une zone de blocs de données (DBA).

3. Procédé de traduction flash selon la revendication précédente, **caractérisé en ce qu'**il comprend, à chaque fois qu'une page est écrite dans la mémoire flash (2), une étape pour ajouter une entrée à la zone de blocs de mappage (MBA), chaque entrée contenant un drapeau de validité, un numéro de page logique (LPN) et un numéro de page physique (PPN) qui lui est associé.

4. Procédé de traduction flash selon la revendication précédente, **caractérisé en ce qu'**il comprend en outre une étape pour inscrire une copie d'une table de mappage de la mémoire vive (RAM) dans la mémoire flash (2), ladite copie étant exploitée en tant que table de recherche de mappage (MLT).

5. Procédé de traduction flash selon la revendication précédente, **caractérisé en ce qu'**il comprend en outre une étape pour indexer la table de recherche de mappage (MLT) par des numéros de page logique (LPN), ladite table de recherche de mappage (MLT) contenant le numéro de page physique (PPN) et un identifiant de mappage (MID).

6. Procédé de traduction flash selon la revendication précédente, **caractérisé en ce qu'**il comprend en outre une étape pour gérer un tableau d'invalidité sous la forme d'une table de recherche de validité (VLT) qui est indexée par le numéro de page physique (PPN).

7. Procédé de traduction flash selon la revendication 5 ou 6, **caractérisé en ce qu'**il comprend en outre une sauvegarde dans la mémoire vive (RAM) de :
- l'adresse du bloc de la mémoire flash (2) en cours d'écriture, appelée page de données actuelle (CDP),
- l'adresse de la dernière adresse d'identifiant de mappage (MID), appelée page de mappage actuelle (CMP),
- le nombre de blocs libres.

8. Procédé de traduction flash selon la revendication précédente, **caractérisé en ce qu'**il comprend un processus d'initialisation mis en œuvre au démarrage d'un lancement du lanceur spatial (2), ledit processus d'initialisation comprenant une étape pour lire la première page de chaque bloc du tableau de blocs de mappage (MBA), cette étape de lecture comprenant les étapes suivantes :
- lecture d'une valeur de validité d'une première unité dudit tableau de blocs de mappage (MBA),
- si cette valeur est différente de 0xF, lecture de toutes les pages successives dudit bloc jusqu'à atteindre une validité de 0xF.

9. Procédé de traduction flash selon la revendication précédente, **caractérisé en ce qu'**il comprend en outre un processus d'écriture dans la mémoire flash (2), ledit processus d'écriture comprenant les étapes suivantes :
- obtenir un nouveau numéro de page physique PPN libre sur lequel écrire,
- écrire des données à cette adresse dans la mémoire flash (2).

10. Procédé de traduction flash selon la revendication précédente, **caractérisé en ce qu'**il comprend en outre les étapes suivantes :
- récupérer l'ancien ensemble d'entrées pour un numéro de page logique LPN donné,
- si l'entrée est valide,
- invalider cette entrée dans la table de recherche de validité VLT et le tableau de blocs de mappage MBA et
- diminuer le nombre de pages valides dans le bloc correspondant dans le tableau de statut de blocs BSA,
- obtenir un nouvel identifiant de mappage MID libre,
- y écrire la nouvelle entrée dans le tableau MBA et
- mettre à jour les tables de recherche de mappage MLT et de recherche de validité VLT.

11. Procédé de traduction selon l'une quelconque des revendications 8 à 10, **caractérisé en ce qu'**il comprend en outre un processus d'allocation d'un numéro de page physique, ledit procédé d'allocation comprenant une étape pour attribuer un nouveau numéro de page physique (NPP) par incrémentation de la valeur de page de données actuelle (CDP) et incrémentation de la valeur de bloc si le bloc de données actuel est plein.

12. Procédé de traduction flash selon l'une quelconque des revendications 8 à 11, **caractérisé en ce qu'**il comprend en outre un processus de récupération de blocs, ledit processus de récupération de bloc comprenant les étapes suivantes :
- sélectionner un bloc rempli avec le plus grand nombre de pages non valides,
- déplacer les pages valides vers le bloc de données actuellement écrit, et
- effacer ce bloc pour créer un nouveau bloc libre.

13. Procédé de traduction flash selon la revendication précédente, **caractérisé en ce que** le processus de récupération de blocs comprend en outre :
- surveiller périodiquement la quantité de blocs libres disponibles et
- créer des blocs libres chaque fois que cette quantité passe sous un certain seuil.

14. Système ordinateur de bord (100) embarqué dans un lanceur spatial (1), comprenant une unité de contrôle et de traitement (102), une unité mémoire RAM (101) prévue pour recevoir des fichiers système (13) transmis depuis un segment sol (3) et une unité mémoire flash (2) prévue pour y écrire des données de mission et de configuration contenus dans lesdits fichiers système (13), ladite unité de contrôle et de traitement (102) implémentant un procédé de traduction flash selon l'une quelconque des revendications précédentes pour écrire lesdites données de mission et de configuration dans ladite unité mémoire flash (2).

15. Lanceur spatial (1) équipé d'un système ordinateur de bord (100) selon la revendication précédente.
